# EUROPEAN PATENT SPECIFICATION

(11) **EP 1 788 636 B1**
(45) Date of publication and mention of the grant of the patent: **17.02.2010**
(21) Application number: 05770451.2
(22) Date of filing: 09.08.2005
(51) Int. Cl.: H01L 31/032

(54) **CIS TYPE COMPOUND SEMICONDUCTOR THIN FILM SOLAR CELL AND METHOD FOR PREPARING LIGHT-ABSORBING LAYER OF SAID SOLAR CELL**
VERBUND-HALBLEITER-DÜNNFILM-SOLARZELLE DES CIS-TYPS UND VERFAHREN ZUR HERSTELLUNG EINER LICHTABSORBTIONSSCHICHT DER SOLARZELLE
CELLULE SOLAIRE SEMI-CONDUCTRICE A COUCHE MINCE A BASE DE COMPOSE DE TYPE CIS ET PROCEDE POUR LA FABRICATION D'UNE COUCHE D'ABSORPTION DE LA LUMIERE DE LADITE CELLULE SOLAIRE

(30) Priority: 09.08.2004 JP 2004232238
(43) Date of publication of application: 23.05.2007
(73) Proprietor: Showa Shell Sekiyu Kabushiki Kaisha, Minato-ku Tokyo 135-8074 (JP)
(72) Inventor: KURIYAGAWA, Satoru Showa Shell Sekiyu K. K., Tokyo 135-8074 (JP); NAGOYA, Yoshinori Makkari High School, Hokkaido 048-1611 (JP); TANAKA, Yoshiaki Showa Shell Sekiyu K. K., Tokyo 135-8074 (JP)
(74) Representative: HOFFMANN EITLE
(86) International application number: PCT/JP2005/014570
(87) International publication number: WO 2006/016577

(56) References cited:
- EP-A- 0 978 882
- EP-A- 1 167 587
- EP-A- 1 235 280
- WO-A-97/23004
- JP-A- 9 082 992
- JP-A- 11 284 209
- JP-A- 11 298 016
- JP-A- 2003 273 135
- US-A- 5 985 691
- NEGAMI T ET AL: 'Production technology for CIGS thin film solar cells.' THIN SOLIF FILMS. vol. 403, no. 404, 2002, pages 197 - 203, XP004334491

## Description

### Technical Field

The present invention relates to a CIS compound semiconductor thin-film solar cell and a method of forming the light absorption layer of the solar cell.

### Background Art

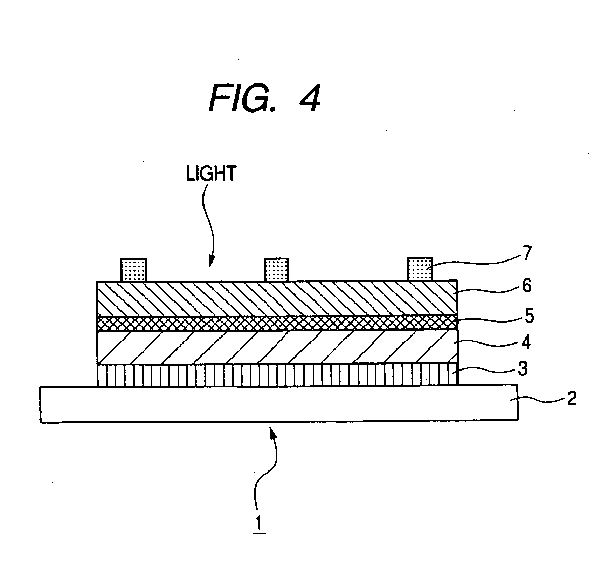

As shown in Fig. 4, the basic structure of a CIS compound semiconductor thin-film solar cell 1 comprises a multilayer structure superposed thereon in the following order, a metallic back electrode 3, a light absorption layer 4, an interfacial layer (buffer layer) 5, a window layer 6, and an upper electrode 7 on a (soda-lime) glass substrate 2. The light absorption layer is constituted of a thin filmof a CIS compound semiconductor such as a p-type Cu-III-VI₂ Group chalcopyrite semiconductor, e.g., copper indium diselenide (CIS), copper indium gallium diselenide (CIGS), or copper indium gallium diselenide sulfide (CIGSS), or CIGS having a thin layer including CIGSS as a surface layer.

In CIS compound semiconductor thin-film solar cells, there is a tendency that the contents of the gallium and sulfur which are components of the light absorption layer thereof are increased in order to improve conversion efficiency (see, for example, patent documents 1, 2, and 3). Patent document 1 discloses a method of forming the light absorption layer of a CIS compound semiconductor thin-film solar cell. In this method, a gallium content in the range of from 0.117 to 0.434 (gallium proportion in Group III elements) is attained by the multi-source deposition method to thereby obtain a high conversion efficiency. However, in the case where a thin film of a compound semiconductor having a high gallium proportion y (y=Ga/ (Ga+In)) is to be formed by the multi-source deposition method, this method as an industrial technique has the following serious problems: (1) gallium should be used in an increased amount, resulting in a cost increase; (2) uniformity throughout a large area in multi-source deposition is difficult to secure and the film formation apparatus is complicated and expensive; and (3) the film formation should be conducted at a high temperature, resulting in many factors which limit substrate materials. On the other hand, the selenization method, which is highly suitable for industrially forming a thin film of a CIS compound semiconductor evenly over a large area, is based on the thermal diffusion of constituent elements and, hence, has had problems, for example, that (4) high-temperature processing should be conducted for a prolonged period because the rate of diffusion of gallium is far lower than those of other elements.

In some CIS compound semiconductor thin-film solar cells, the light absorption layer has a composition which includes copper and indium as components of the layer and in which the proportion of the copper to the indium has been reduced in order to improve conversion efficiency (see, for example, patent documents 4, 5, 6, and 7). In such light absorption layers of the CIS compound semiconductor thin-film solar cells or the processes for producing these which are described in patent documents 4, 5, and 7, the components of the light absorption layers do not include gallium. Furthermore, in producing the solar cell described in patent document 4, a solid selenium layer formed by vapor deposition is used as a selenium source. In this respect, the solar cell described in patent document 4 differs from that of the invention, for which a gas is used as a selenium source. In producing the solar cells described in patent documents 6 and 7, a CIS film is formed by the simultaneous deposition method. These solar cells differ from that of the invention, for which a multilayered precursor film comprising a Cu-Ga alloy layer and an indium layer and having a given composition is produced by sputtering and is heat-treated at a given low temperature in an atmosphere comprising a gas containing selenium and/or sulfur. Patent document 5 includes a statement concerning CIGS and CIGSS for use as the light absorption layer thereof. However, this light absorption layer is not one in which the gallium proportion y (y=Ga/(Ga+In)) is low as in the invention. The documents US-A-5985691, EP-A 1235280 and JP 11-284209 A disclose CIGS-based solar cell devices.

Patent Document 1: Japanese Patent No. 3244408 (JP-A-9-82992) Patent Document 2: Japanese Patent No. 3249408 (JP-A-10-135495) Patent Document 3: Japanese Patent No. 3249407 (JP-A-10-135498) Patent Document 4: JP-A-4-127483
Patent Document 5: JP-A-9-506475
Patent Document 6: JP-A-4-369871
Patent Document 7: JP-A-8-111425

### Disclosure of the Invention

### Problems that the Invention is to Solve

The invention has been achieved in order to eliminate the problems described above. An object of the invention is to produce a CIS compound semiconductor thin-film solar cell having a high conversion efficiency by conducting a process for forming a thin film of a CIS compound semiconductor, (1) at low cost, (2) evenly over a large area, while enabling (3) a wide choice of substrate materials and maintaining (4) high productivity.

### Means for Solving the Problems

(1) The invention provides (the light absorption layer of) a CIS compound semiconductor thin-film solar cell having a multilayer structure, which comprises a substrate and, superposed thereon in the following order, a metallic back electrode, alight absorption layer, an interfacial layer (buffer layer), a window layer, and an upper electrode, **characterized in that** the light absorption layer comprises a compound represented by Cuₓ(In_{1-y} Ga_{y}) (Se_{1-z}S_{z})₂ and having a chalcopyrite type structure, the proportions of the components satisfying 0.86≤x≤0.98 (preferably 0.90≤x≤0.96), 0.05≤y≤0.25, and 0≤z≤0.3.

(2) The invention further provides the CIS compound semiconductor thin-film solar cell according to the above (1), wherein the light absorption layer comprises a compound represented by Cuₓ(In_{1-y} Ga_{y}) (Se_{1-z}S_{z})₂ and having a chalcopyrite type structure, the proportions of the components satisfying 0.86≤x≤0.98 (preferably 0.90≤x≤0.96), 0.05≤y≤0.25, 0≤z≤0.3, x=αT+β, α=0.015y-0.00025, and β=-7.9y+1.105, provided that T (°C) is anneal temperature and the allowable range for x is ±0.02.

(3) The invention still further provides the CIS compound semiconductor thin-film solar cell according to the above (1) or (2), wherein the substrate is a soda-lime glass.

(4) The invention furthermore provides a method of forming the light absorption layer of a CIS compound semiconductor thin-film solar cell having a multilayer structure, wherein the solar cell comprises a substrate and, superposed thereon in the following order, a metallic back electrode, a light absorption layer, an interfacial layer (buffer layer), a window layer, and an upper electrode, wherein the light absorption layer comprises a compound represented by Cuₓ(In_{1-y} Ga_{y}) (Se_{1-z} S_{z})₂ and having a chalcopyrite type structure, the proportions of the components satisfying 0.86≤x≤0.98 (preferably 0.90≤x≤0.96), 0.05≤y≤0.25, and 0≤z≤0.3, and that the light absorption layer is formed by the selenization method at a low temperature.

(5) The invention furthermore provides the method of forming the light absorption layer of a CIS compound semiconductor thin-film solar cell according to the above (4), characterized by forming a precursor for the light absorption layer, the precursor being constituted of elements comprising Cuₓ, In_{1-y}, and Ga_{y}, wherein the proportions of the components satisfy x=αT+β, α=0.015y-0.00025, and β=-7.9y+1.105, provided that T (°C) is anneal temperature and the allowable range for x is ±0.02.

(6) The invention furthermore provides the method of forming the light absorption layer of a CIS compound semiconductor thin-film solar cell according to the above (4) or (5), wherein the anneal temperature T (°C) for forming the light absorption layer is in the range of about 500°C≤T≤550°C (preferably 500°C≤T≤530°C, more preferably 505°C≤T≤515°C).

### Advantages of the Invention

According to the invention, the CIS compound semiconductor thin-film solar cell can have a high conversion efficiency even when the gallium proportion y (y=Ga/(Ga+In)) in the light absorption layer is low. In addition, since the light absorption layer is formed by the low-temperature selenization method, not only improved productivity and a reduction in production energy cost are attained but also substrate materials can be selected from a wider range.

### Best Mode for Carrying Out the Invention

Embodiments of the invention will be explained below.
First, the basic structure of the CIS compound semiconductor thin-film solar cell 1 is a multilayer structure which, as shown in Fig. 4, comprises a substrate 2 and, superposed thereon in the following order, a metallic back electrode 3, a light absorption layer 4, an interfacial layer (buffer layer) 5, a window layer 6, and an upper electrode 7. The metallic back electrode 3 formed on the glass substrate 2 is a highly corrosion-resistant metal having a high melting point, e.g., molybdenum or titanium, which has a thickness of 1-2 µm. The light absorption layer 4 is a thin film of a CIS compound semiconductor showing p-type conduction, and it has a thickness of 1-3 µm. Namely, the light absorption layer is constituted of a Cu-III-VI₂ Group chalcopyrite (type) semiconductor, e.g., copper indium diselenide (CIS), copper indium gallium diselenide (CIGS), or copper indium gallium diselenide sulfide (CIGSS), or CIGS having a thin layer including CIGSS as a surface layer. The interfacial layer (buffer layer) 5 is a thin film of a II-VI Group compound semiconductor which is transparent, has high resistance, and may contain a hydroxide. The window layer 6 is a transparent thin conductive film of a metal oxide semiconductor which is made of zinc oxide showing n-type conduction, has a large band gap width, is transparent and electrically conductive, and has a thickness of 0.5-3 µm. The light absorption layer 4 and the window layer 6 constitute a p-n junction, which serves to produce a photovoltaic effect for the solar cell. However, the surface of the light absorption layer (p-type) 4 has low-resistance parts in which the content of copper, selenium, etc. is high and which have properties of metalloids. It is therefore impossible to form a completely insulated p-n junction between the light absorption layer 4 and the window layer 6. For the purpose of covering such low-resistance parts in the surface of the light absorption layer (p-type) 4, an interfacial layer (buffer layer) 5 which is transparent and has high resistance is formed on the light absorption layer (p-type) 4. The interfacial layer (buffer layer) 5, window layer 6, and upper electrode 7 which are formed over the light absorption layer 4 are made of transparent materials so as to facilitate sunlight transmission to the light absorption layer 4.

The invention relates to the CIS compound semiconductor thin-film solar cell described above and a method of forming the light absorption layer of the solar cell. As stated hereinabove, there has been a tendency in CIS compound semiconductor thin-film solar cells that the contents of the gallium and sulfur which are components of the light absorption layer are increased in order to improve conversion efficiency. In the invention, however, the conversion efficiency of the solar cell, even when the gallium proportion y (y=Ga/ (Ga+In)) has been reduced, compares favorably with that of solar cells having a high gallium proportion y. Furthermore, the method of light absorption layer formation in which a light absorption layer is formed at a low temperature by the selenization method, which is based on the thermal diffusion of constituted elements unlike the multi-source deposition method, is effective in obtaining a thin compound semiconductor film which is homogeneous and of good quality. In addition, improved productivity and a reduction in production energy cost are attained and substrate materials can be selected from a wider range.

In the CIS compound semiconductor thin-film solar cell 1 of the invention, the light absorption layer 4, in particular, comprises a compound represented by Cuₓ(In_{1-y} Ga_{y}) (Se_{1-z} S_{z})₂ and having a chalcopyrite type structure, the proportions of the components satisfying 0.86≤x≤0.98 (preferably 0.90≤x≤0.96), 0.05≤y≤0.25, 0≤z≤0.3, x=αT+β, α=0.015y-0.00025, and β=-7.9y+1.105, provided that T (°C) is anneal temperature and the allowable range for x is ±0.02.

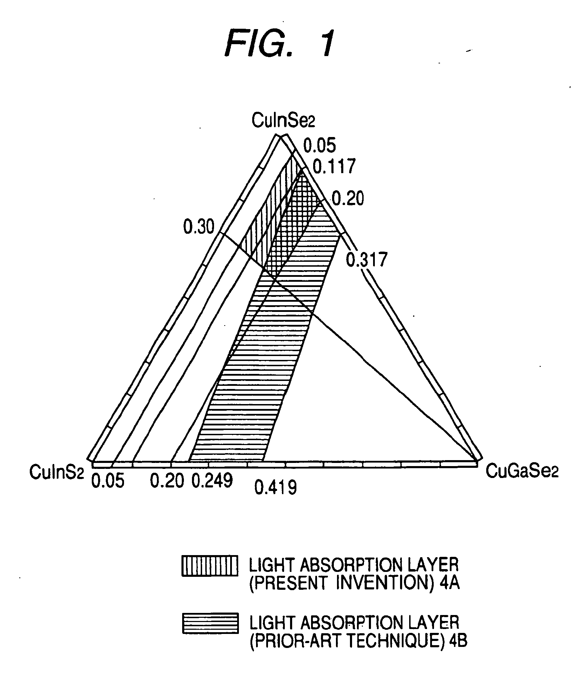

Fig. 1 is a presentation showing a comparison between the compositional range of the light absorption layer 4A (when the proportion of copper is taken as 1, i.e., x=1) of the CIS compound semiconductor thin-film solar cell of the invention and that of the light absorption layer 4B of a CIS compound semiconductor thin-film solar cell according to a prior-art technique (patent document 1). As shown in Fig. 1, an overlap appears to be present between the compositional range of the light absorption layer 4A and the compositional range of the light absorption layer 4B. However, the proportion of copper in this case is not 1, i.e., does not satisfy x=1 as in the case described above, but is in the range of 0.86≤x≤0.98 (preferably 0.90≤x≤0.96). It is **characterized in that** the proportion of copper x to Group III elements (e.g., Ga+In) (hereinafter that proportion is referred to as copper proportion x) is changed by changing the gallium proportion y (y=Ga/(Ga+In)). As a result, there is no overlap between the compositional range of the light absorption layer 4A and the compositional range of the light absorption layer 4B.

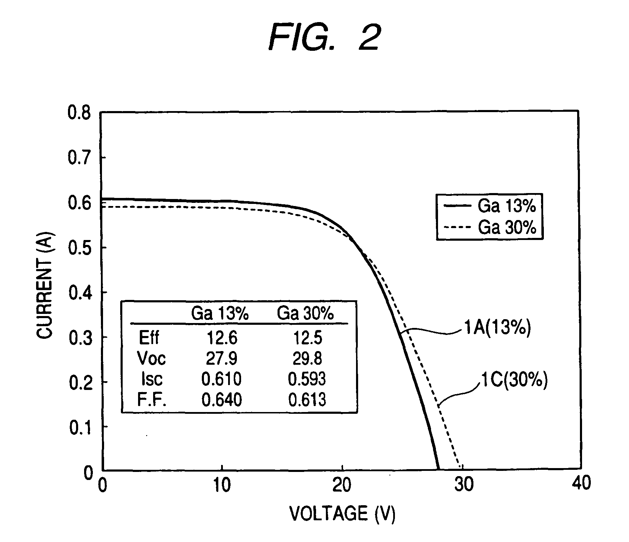

Fig. 2 is a presentation showing a comparison between the voltage/current characteristics of a solar cell 1A according to the invention employing a thin film of a CIS compound semiconductor having a low gallium proportion y (y is 13%, provided that y=Ga/(Ga+In)) as a light absorption layer 4A and those of a solar cell 1C employing a thin film of a CIS compound semiconductor having a high gallium proportion y (y is 30%) as a light absorption layer 4C. It was found that there is no difference between the two solar cells in voltage/current characteristics and conversion efficiency.
Incidentally, in the case where the gallium proportion y is 13%, S/(S+Se) is 20%. Consequently, the compositional range of this light absorption layer does not overlap that of the light absorption layer 4B of the CIS compound semiconductor thin-film solar cell according to the prior-art technique (patent document 1).

In the case of the solar cell 1C, which employs a light absorption layer 4C comprising a thin film of a CIS compound semiconductor having a high gallium proportion y (y is 30%), an anneal temperature of 530°C or higher is necessary. In contrast, in the case of the solar cell 1A, which employs a light absorption layer 4A comprising a thin film of a CIS compound semiconductor having a low gallium proportion y (y is 13%), substrate anneal is conducted at a low temperature of 520°C or below and, hence, inexpensive soda-lime glasses can be used which have a heat distortion point of about 510-520°C and are for use in building applications, etc. The anneal temperature T (°C) for the thin CIS compound semiconductor film can be in the range of 500°C≤T≤550°C, and is preferably 500°C≤T≤530°C, more preferably 505°C≤T≤515°C. The values of anneal temperature T (°C) used herein are estimates of substrate temperature, which are [oven temperature]-30°C.

In forming the light absorption layer 4A of the CIS compound semiconductor thin-film solar cell of the invention by the selenization method through low-temperature burning (520°C or lower), gallium diffusion is not complete as stated hereinabove. Because of this, the optimal value of copper proportion x varies in the range of 0.86≤x≤0.98 (preferably 0.90≤x≤0.96) according to the gallium proportion y and the anneal temperature.

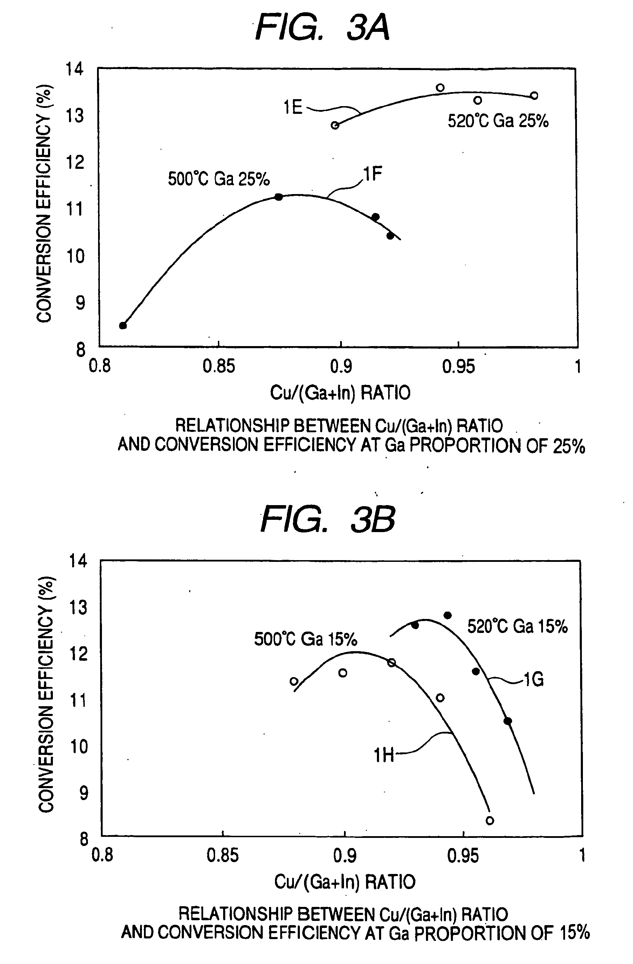

Fig. 3 shows experimental data indicating the relationship between Cu/(Ga+In) ratio x and conversion efficiency (%): (a) is the case of solar cells employing a light absorption layer having a gallium proportion y of 25%; and (b) is the case of solar cells employing a light absorption layer having a gallium proportion y of 15%.
Fig. 3 (a) shows the following. In the solar cells 1E employing a light absorption layer having a gallium proportion y of 25% and formed through anneal at 520°C, sufficient gallium diffusion occurred because of the anneal temperature as high as 520°C and an optimal value of conversion efficiency is obtained when the Cu/(Ga+In) ratio is around 0.96. In contrast, in the solar cells 1F employing a light absorption layer having a gallium proportion y of 25% and formed through anneal at 500°C, an optimal value of conversion efficiency is obtained when the Cu/(Ga+In) ratio is around 0.88.
Fig. 3 (b) shows the following. In the case of the solar cells 1G and 1H employing a light absorption layer having a gallium proportion y of 15%, optimal values of Cu/ (Ga+In) ratio are kept high as compared with the case where the gallium proportion y is 25%, although the light absorption layers have undergone low-temperature anneal (500-520°C). This is because the total amount of gallium to be diffused was smaller.
It was found from those experimental results that even through low-temperature anneal, a CIS compound semiconductor thin-film solar cell having a higher conversion efficiency than in the case of production through the low-temperature anneal of a composition having a high gallium proportion can be produced when the gallium proportion y is kept relatively low (about 15%) and a Cu/ (Ga+In) ratio suitable for the gallium proportion y and anneal temperature T (°C) is used. Incidentally, the anneal temperature T (°C) used here is an estimate of substrate temperature, which is [oven temperature]-30°C.

A relational expression concerning the proportions of gallium and copper only is roughly as follows:
x=αT+β (wherein x is the proportion of copper; y is Ga/(In+Ga); and α=0.015y-0.00025 and β=-7.9y+1.105, provided that T (°C) is anneal temperature and 500°C≤T≤550°C), the allowable range for x being ±0.02.

The light absorption layer of the CIS compound semiconductor thin-film solar cell of the invention enables the attainment of a high conversion efficiency even when the gallium proportion y is in a low-proportion range as shown in Fig. 3. In addition, by employing the low-temperature selenization method in forming the layer, not only improved productivity and a reduction in production energy cost are attained but also substrate materials can be selected from a wider range.

The method of forming the light absorption layer of the CIS compound semiconductor thin-film solar cell of the invention is explained below in detail.
After a metallic back electrode is formed on a substrate, the light absorption layer comprising Cu, In, Ga, Se, and S is formed by selenization by low-temperature burning such as that shown in patent document 2 or 3.
For example, a light absorption layer precursor (precursor film) comprising a Cu-Ga alloy layer and an indium layer is formed by sputtering so as to have the following component proportions, and this precursor film is heat-treated at a low temperature such as that shown above in an atmosphere comprising a selenium- and/or sulfur-containing gas. Thus, the light absorption layer having the composition described above is formed. The light absorption layer precursor (precursor film) is constituted of elements comprising Cuₓ, In_{1-y}, and Ga_{y} and the proportions thereof satisfy 0.86≤x≤0.98 (preferably 0.90≤x≤0.96), 0.05≤y≤0.25, (0≤z≤0.3), x=αT+β, α=0.015y-0.00025, and β=-7.9y+1.105, provided that T (°C) is anneal temperature and the allowable range for x is ±0.02.
This application is based on a Japanese patent application filed on August 9, 2004 (Application No. 2004-232238), the contents thereof being herein incorporated by reference.

### Brief Description of the Drawings

[Fig. 1] Fig. 1 is a presentation showing a comparison between the composition of the light absorption layer 4A (in which x=1) of the CIS compound semiconductor thin-film solar cell of the invention and the compositional range of the light absorption layer 4B of a CIS compound semiconductor thin-film solar cell according to a prior-art technique (patent document 1).
[Fig. 2] Fig. 2 is a presentation showing a comparison between the solar cell characteristics of a CIS compound semiconductor thin-film solar cell 1A according to the invention employing a light absorption layer 4A having a low gallium proportion y (y is 13%) and those of a CIS compound semiconductor thin-film solar cell 1C employing a light-absorption layer 4C having a high gallium proportion (y is 30%).
[Fig. 3] (a) is a presentation showing experimental data indicating the relationship between Cu/(Ga+In) ratio and conversion efficiency in solar cells 1E employing a light absorption layer having a gallium proportion y of 25% and formed through anneal at 520°C and in solar cells 1F employing a light absorption layer having a gallium proportion y of 25% and formed through anneal at 500°C. (b) is a presentation showing experimental data indicating the relationship between Cu/(Ga+In) ratio and conversion efficiency in solar cells 1G employing a light absorption layer having a gallium proportion y of 15% and formed through anneal at 520°C and in solar cells 1H employing a light absorption layer having a galliumproportion y of 15% and formed through anneal at 500°C.
[Fig. 4] Fig. 4 is a view illustrating the basic constitution of a CIS compound semiconductor thin-film solar cell according to the invention.

### Description of Reference Numerals and Signs

1 CIS compound semiconductor thin-film solar cell
1A CIS compound semiconductor thin-film solar cell of the invention
1A solar cell of the invention employing light absorption layer 4A comprising thin film of CIS compound semiconductor having low gallium proportion y (y is 13%)
1B CIS compound semiconductor thin-film solar cell of prior-art technique
1C solar cell employing light absorption layer 4C comprising thin film of CIS compound semiconductor having high gallium proportion y (y is 30%)
1E solar cell employing light absorption layer having gallium proportion y of 25% and formed through anneal at 520°C
1F solar cell employing light absorption layer having gallium proportion y of 25% and formed through anneal at 500°C
1G solar cell employing light absorption layer having gallium proportion y of 15% and formed through anneal at 520°C
1H solar cell employing light absorption layer having gallium proportion y of 15% and formed through anneal at 500°C
2 substrate
3 metallic back electrode
4 light absorption layer
4A light absorption layer (in which x=1) of CIS compound semiconductor thin-film solar cell of the invention
4A light absorption layer comprising thin film of CIS compound semiconductor having low gallium proportion y (y is 13%) according to the invention
4B light absorption layer of CIS compound semiconductor thin-film solar cell of prior-art technique (cited document 1)
4C light absorption layer comprising thin film of CIS compound semiconductor having high gallium proportion y (y is 30%)
5 interfacial layer (buffer layer)
6 window layer
7 upper electrode

## Claims

1. A CIS compound semiconductor thin-film solar cell (1) having a multilayer structure, which comprises a substrate (2) and, superposed thereon in the following order, a metallic back electrode (3), a light absorption layer (4), an interfacial layer (buffer layer) (5), a window layer (6), and an upper electrode (7),
wherein the light absorption layer comprises a compound represented by Cuₓ(In_{1-y} Ga_{y}) (Se_{1-z}S_{z})₂ and having a chalcopyrite type structure, **characterised by** the proportions of the components satisfying 0.86≤x≤0.98, 0.05≤y≤0.25, and 0≤z≤0.3.

2. The CIS compound semiconductor thin-film solar cell according to claim 1, wherein the light absorption layer comprises a compound represented by Cuₓ(In_{1-y} Ga_{y}) (Se_{1-z}S_{z})₂ and having a chalcopyrite type structure, the proportions of the components satisfying 0.86≤x≤0.98, 0.05≤y≤0.25, 0≤z≤0.3, x=αT+β, α=0.015y-0.00025, and β=-7.9y+1.105, provided that T (°C) is anneal temperature and the allowable range for x is ±0.02.

3. The CIS compound semiconductor thin-film solar cell according to claim 1 or 2, wherein the substrate is a soda-lime glass.

4. A method for forming the light absorption layer of a CIS compound semiconductor thin-film solar cell (1) having a multilayer structure, wherein the solar cell comprises a substrate (2) and, superposed thereon in the following order, a metallic back electrode (3), a light absorption layer (4), an interfacial layer (buffer layer) (5), a window layer (6) and an upper electrode (7),
wherein the light absorption layer comprises a compound represented by Cuₓ(In_{1-y} Ga_{y}) (Se_{1-z} S_{z})₂ and having a chalcopyrite type structure, the proportions of the components satisfying 0.86≤x≤0.98, 0.05≤y≤0.25, and 0≤z≤0.3, and
wherein the light absorption layer is formed by the selenization method at a low temperature.

5. The method for forming the light absorption layer of a CIS compound semiconductor thin-film solar cell according to claim 4, **characterized by** forming a precursor for the light absorption layer, the precursor being constituted of elements comprising Cuₓ, In_{1-y}, and Ga_{y}, wherein the proportions of the components satisfy x=αT+β, α=0.015y-0.00025, and β=-7.9y+1.105, provided that T (°C) is anneal temperature and the allowable range for x is ±0.02.

6. The method for forming the light absorption layer of a CIS compound semiconductor thin-film solar cell according to claim 4 or 5, wherein the anneal temperature T (°C) for forming the light absorption layer is in the range of about 500°C≤T≤550°C.

## Patentansprüche

1. CIS-Verbindungshalbleiter-Dünnschichtsolarzelle (1) mit einer Mehrschichtstruktur, die ein Substrat (2) und darauf in der folgenden Reihenfolge angeordnet eine metallische Rückseitenelektrode (3), eine Lichtabsorptionsschicht (4), eine Grenzflächenschicht (Pufferschicht) (5), eine Fensterschicht (6) und eine obere Elektrode (7) umfasst,
wobei die Lichtabsorptionsschicht eine Verbindung umfasst, die durch Cuₓ(In_{1-y}Ga_{y})(Se_{1-z}S_{z})₂ wiedergegeben ist und eine Struktur vom Chalcopyrit-Typ hat, **dadurch gekennzeichnet, dass** die Anteile der Komponenten 0,86≤x≤ 0,98, 0,05 ≤ y ≤ 0,25 und 0 ≤ z ≤ 0,3 erfüllen.

2. CIS-Verbindungshalbleiter-Dünnschichtsolarzelle gemäß Anspruch 1, in der die Lichtabsorptionsschicht eine Verbindung umfasst, die durch Cuₓ(In_{1-y}Ga_{y})(Se_{1-z}S_{z})₂ wiedergegeben ist und eine Struktur von Chalcopyrit-Typ hat, wobei die Anteile der Komponenten 0,86 ≤ x ≤ 0,98, 0,05 ≤ y ≤ 0,25, 0 ≤ z ≤ 0,3, x = αT + β,
α = 0,015y - 0,00025 und β = -7,9y + 1,105 erfüllen, mit der Maßgabe, dass T (°C) eine Tempertemperatur ist und der erlaubte Bereich für x ±0,02 ist.

3. CIS-Verbindungshalbleiter-Dünnschichtsolarzelle gemäß Anspruch 1 oder 2, in der das Substrat ein Kalknatronglas ist.

4. Verfahren zum Bilden der Lichtabsorptionsschicht einer CIS-Verbindungshalbleiter-Dünnschichtsolarzelle (1) mit einer Mehrschichtstruktur, bei dem die Solarzelle ein Substrat (2) und darauf in der folgenden Reihenfolge angeordnet eine metallische Rückseitenelektrode (3), eine Lichtabsorptionsschicht (4), eine Grenzflächenschicht (Pufferschicht) (5), eine Fensterschicht (6) und eine obere Elektrode (7) umfasst,
wobei die Lichtabsorptionsschicht eine Verbindung umfasst, die durch Cuₓ(In_{1-y}Ga_{y})(Se_{1-z}S_{z})₂ wiedergegeben ist und eine Struktur vom Chalcopyrit-Typ hat, wobei die Anteile der Komponenten 0,86 ≤ x ≤ 0,98, 0,05 ≤ y ≤ 0,25 und 0 ≤ z ≤ 0,3 erfüllen und
bei dem die Lichtabsorptionsschicht durch das Selenisierungsverfahren bei niedriger Temperatur gebildet wird.

5. Verfahren zum Bilden der Lichtabsorptionsschicht einer CIS-Verbindungshalbleiter-Dünnschichtsolarzelle gemäß Anspruch 4, **dadurch gekennzeichnet, dass** ein Vorläufer für die Lichtabsorptionsschicht gebildet wird, wobei der Vorläufer aus Elementen besteht, die Cuₓ, In_{1-y} und Ga_{y} umfassen, wobei die Anteile der Verbindungen x = αT + β, α = 0,015y - 0,00025 und β = -7,9y + 1,105 erfüllen mit der Maßgabe, dass T (°C) eine Tempertemperatur ist und der erlaubte Bereich für x ±0,02 ist.

6. Verfahren zum Bilden der Lichtabsorptionsschicht einer CIS-Verbindungshalbleiter-Dünnschichtsolarzelle gemäß Anspruch 4 oder 5, bei dem die Tempertemperatur T (°C) für die Bildung der Lichtabsorptionsschicht im Bereich von 500°C ≤ T ≤ 550°C liegt.

## Revendications

1. Cellule (1) solaire à film mince semi-conducteur à base d'un composé CIS ayant une structure multicouche, qui comprend un substrat (2) et, sur lequel sont superposés dans l'ordre suivant, une électrode (3) arrière métallique, une couche (4) d'absorption de lumière, une couche inter-faciale (couche tampon) (5), une couche fenêtre (6), et une électrode supérieure (7),
où la couche d'absorption de lumière comprend un composé représenté par Cuₓ (In_{1-y}Ga_{y}) (Se_{1-z}S_{z})₂ et, ayant une structure du type chalcopyrite, **caractérisée par** les proportions des composantes satisfaisant 0,86 ≤ x ≤ 0,98, 0,05 ≤ y ≤ 0,25, et 0 ≤ z ≤ 0,3.

2. Cellule (1) solaire à film mince semi-conducteur à base d'un composé CIS selon la revendication 1, dans laquelle la couche d'absorption de lumière comprend un composé représenté par Cuₓ (In_{1-y} Ga_{y}) (Se_{1-z}S_{z})₂ et ayant une structure du type chalcopyrite, les proportions des composantes satisfaisant 0,86 ≤ x ≤ 0,98, 0,05 ≤ y ≤ 0,25, 0 ≤ z ≤ 0,3, x=αT+β, α=0,015y-0,00025, et β=-7,9y+1,105, à condition que T (°C) soit une température de recuit et la gamme admissible pour x soit ± 0,02.

3. Cellule (1) solaire à film mince semi-conducteur à base d'un composé CIS selon la revendication 1 ou 2, dans laquelle le substrat est un verre sodo-calcique.

4. Procédé de formation de la couche d'absorption de lumière d'une cellule (1) solaire à film mince semi-conducteur à base d'un composé CIS ayant une structure multicouche, dans lequel la cellule solaire comprend un substrat (2) et, sur lequel sont superposés dans l'ordre suivant, une électrode arrière métallique (3), une couche d'absorption de lumière (4), une couche inter-faciale (couche tampon) (5), une couche fenêtre (6), et une électrode supérieure (7),
où la couche d'absorption de lumière comprend un composé représenté par Cuₓ (In_{1-y} Ga_{y}) (Se_{1-z} S_{z})₂ et ayant une structure du type chalcopyrite, les proportions des composantes satisfaisant 0,86 ≤ x ≤ 0,98, 0,05 ≤ y ≤ 0,25, et 0 ≤ z ≤ 0,3, et
où la couche d'absorption de lumière est formée par le procédé de sélénisation à une température basse.

5. Procédé de formation de la couche d'absorption de lumière d'une cellule solaire à film mince semi-conducteur à base d'un composé CIS selon la revendication 4, **caractérisé par** la formation d'un précurseur pour la couche d'absorption de lumière, le précurseur étant composé d'éléments comprenant du Cuₓ, du In_{1-y}, et du Ga_{y}, où les proportions des composantes satisfont x=αT+β, α=0,015y-0,00025, et β=-7,9y+1,105, à condition que T (°C) soit une température de recuit et la gamme admissible pour x soit ± 0,02.

6. Procédé de formation de la couche d'absorption de lumière d'une cellule solaire à film mince semi-conducteur à base d'un composé CIS selon la revendication 4 ou 5, dans lequel la température T (°C) pour former la couche d'absorption de lumière se trouve dans la gamme de 500°C≤T≤550°C environ.
